# EUROPEAN PATENT APPLICATION

(11) **EP 4 636 792 A1**
(43) Date of publication of application: **22.10.2025**
(21) Application number: 25170691.7
(22) Date of filing: 15.04.2025
(51) Int. Cl.: H01F 17/06, H01F 27/40, H02K 1/00, H02K 7/00, H02M 7/00

(54) **BUSBAR FILTER**

(30) Priority: 16.04.2024 US 202463634912 P; 14.04.2025 US 202519177653
(71) Applicant: CYNTEC CO., LTD., Hsinchu 30076 (TW)
(72) Inventor: Chiu, Kun-Ping, 30076 Hsinchu (TW); Hsieh, Hsieh-Shen, 30076 Hsinchu (TW)
(74) Representative: Straus, Alexander

(57) **Abstract**

A busbar filter including a core with a through hole, two busbars extending through the through hole, and a first over-molding part formed on the two busbars and between the two busbars and the core, wherein the first over-molding part fills up gaps between the two busbars and a remaining space in the through hole.

## Description

### Field of the Invention

The present invention generally relates to a busbar filter, and more specifically, to a busbar filter with over-molding parts for electrically insulating busbars, core and the lead frame mounted thereon.

### Background of the Invention

A busbar filter is commonly used in electrical and electronic systems to filter out unwanted frequencies, harmonics, or noise on the power supply lines. Busbars are conductive materials that distribute electrical power within a system, and when integrated with a filter, they help ensure that the delivered power remains clean and stable.

In electrical and electronic equipment, insulation distances are critical to ensure safe operation without posing a risk to users or other devices. Insulation distance refers to the physical gap between components with different electrical potentials (such as between conductors and grounded parts or between conductors and other electrical elements). This gap must be sufficiently large to prevent short circuits or electrical faults. Designers must calculate appropriate insulation distances based on safety standards, which are typically determined by the rated operating voltage, creepage distance, and clearance distance.

In traditional busbar filter designs, the filtering effect is achieved through the connection between the PCB and the capacitor. In terms of safety regulations, the insulation distance between the PCB and the busbar is calculated using the point-to-point (linear) distance along the plane. As the input voltage increases, the required insulation distance also increases. Consequently, the safety distance between the busbar and the capacitor becomes larger, leading to an increase in product size and higher production costs. Therefore, it is necessary for those skilled in the art to modify the busbar filter design to improve insulation performance between components, increase space utilization, and reduce costs.

### Summary of the Invention

In view of the deficiencies in the prior art described above, the present invention hereby provides a novel busbar filter, characterized by over-molding parts formed between the busbars, core, and the lead frames mounted thereon, which enhance insulation performance. Additionally, the flexible lead frames are used in place of traditional PCBs to connect the capacitors, resulting in improved space utilization. As a result, the required safety distance and product size is reduced, and production costs are lowered.

The objective of present invention is to provide a busbar filter, including: a core with a through hole; two busbars extending along a first direction through the through hole, wherein each of the two busbars comprises a first end and a second end; and a first over-molding part formed on the two busbars and between the two busbars and the core, wherein the first over-molding part fills up gaps between the two busbars and a remaining space in the through hole.

These and other objectives of the present invention will no doubt become obvious to those of ordinary skill in the art after reading the following detailed description of the preferred embodiment that is illustrated in the various figures and drawings.

### Brief Description of the Drawings

FIG. 1 illustrates an isometric view of a busbar filter in accordance with a preferred embodiment of the present invention;
FIG. 2 illustrates an exploded view of the busbar filter in accordance with a preferred embodiment of the present invention;
FIG. 3 presents a cross-sectional view of the busbar filter taken along the section line A-A' in FIG. 2 in accordance with the preferred embodiment of the present invention;
FIG. 4 illustrates a top view of the busbar, showing the first over-molding part molded thereon, in accordance with the preferred embodiment of the present invention;
FIG. 5 illustrates a perspective view of the first lead frame, showing the over-molding part molded thereon and the capacitor mounted thereon, in accordance with a preferred embodiment of the present invention;
FIG. 6 illustrates a top view of the first lead frame, showing the over-molding part molded thereon, in accordance with a preferred embodiment of the present invention;
FIG. 7 illustrates a perspective view of the second lead frame, showing the second over-molding part molded thereon and the capacitor mounted thereon, in accordance with a preferred embodiment of the present invention;
FIG. 8 illustrates a top view of the second lead frame, showing the second over-molding part molded thereon, in accordance with a preferred embodiment of the present invention;
FIG. 9 presents a schematic diagram of the busbar filter in accordance with a preferred embodiment of the present invention;
FIG. 10 presents an enlarged view of the second over-molding part in accordance with an embodiment of the present invention;
FIG. 11 presents an enlarged view of the two busbars along with the first over-molding part molded onto them in accordance with an embodiment of the present invention;
FIG. 12 presents an enlarged view of the two busbars along with the first over-molding part molded onto them in accordance with an embodiment of the present invention;
FIG. 13 presents an exploded view of the second lead frame along with the second over-molding part molded onto it and the capacitor mounted thereon in accordance with an alternative embodiment of the present invention;
FIG. 14 presents an exploded view of the second lead frame along with the second over-molding part molded onto it and the capacitor mounted thereon in accordance with an alternative embodiment of the present invention;
FIG. 15 presents an exploded view of the bent busbar in accordance with an alternative embodiment of the present invention; and
FIG. 16 illustrates the busbars in various bending configurations in accordance with an alternative embodiment of the present invention.

Relative dimensions and proportions of parts of the drawings have been shown exaggerated or reduced in size, for the sake of clarity and convenience in the drawings. The same reference signs are generally used to refer to corresponding or similar features in modified and different embodiments.

### Detailed Description

Reference will now be made in detail to exemplary embodiments of the invention, which are illustrated in the accompanying drawings in order to understand and implement the present disclosure and to realize the technical effect. It can be understood that the following description has been made only by way of example, but not to limit the present disclosure. Various embodiments of the present disclosure and various features in the embodiments that are not conflicted with each other can be combined and rearranged in various ways. Without departing from the spirit and scope of the present disclosure, modifications, equivalents, or improvements to the present disclosure are understandable to those skilled in the art and are intended to be encompassed within the scope of the present disclosure.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something). Further, spatially relative terms, such as "beneath," "below," "lower," "above," "upper," and the like, may be used herein for ease of description to describe one element or feature relationship to another element(s) or feature(s) as illustrated in the figures.

As used herein, the term "layer" refers to a material portion including a region with a thickness. A layer can extend over the entirety of an underlying or overlying structure, or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layer thereupon, thereabove, and/or therebelow. A layer can include multiple layers. For example, an interconnect layer can include one or more conductor and contact layers (in which contacts, interconnect lines, and/or through holes are formed) and one or more dielectric layers.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. Additionally, the term "based on" may be understood as not necessarily intended to convey an exclusive set of factors, but may allow for the presence of other factors not necessarily expressly described, again depending at least in part on the context.

It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

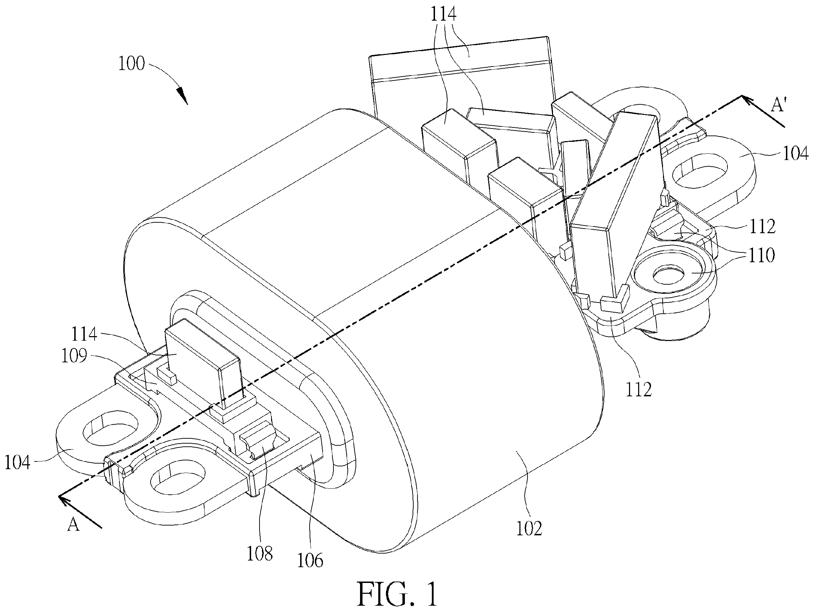

First, please refer to FIG. 1, which presents an isometric view of a busbar filter 100 in accordance with a preferred embodiment of the present invention. The busbar filter 100 primarily comprises a core 102, two busbars 104, a first over-molding part 106, a first lead frame 108, a second lead frame 110, and a second over-molding part 112. Among these components, the core 102 is a magnetic core containing internal windings or coils inside - such as a common mode choke - which serves as a passive electromagnetic component. In this case, part of the two busbars 104 can be regarded as windings or coils in the core 102. The core material is typically magnetic material such as ferrite, iron powder, or a multi-layer stack of nanocrystalline magnetic materials. It allows desired electrical signals to pass through power lines (such as from switching power supplies or motors) while filtering out the unwanted high-frequency noise signal generated by external sources or other circuits of the system. By suppressing common mode electromagnetic interference (EMI), the common mode choke helps protect sensitive circuits and maintain signal integrity during data transmission. Additionally, it enhances the system's electromagnetic compatibility (EMC), ensuring compliance with international electromagnetic interference standards.

Still referring to FIG. 1, the busbar 104 is a metallic conductor designed to efficiently distribute large amounts of electric current within electrical systems. It is typically a solid strip or bar made of high-conductivity metals, such as copper, aluminum, or the alloy thereof, chosen for their excellent electrical performance and mechanical durability. The busbar 104 enables current distribution to multiple circuits or components, offering lower resistance and reduced power loss compared to conventional wiring. This makes it ideal for high-current applications, including electric vehicles (EVs), power distribution units (PDUs), and industrial power systems. In filter applications, the busbars 104 not only function as current conductors but also interact with magnetic components (i.e. the core 102) to filter out electromagnetic noise. This allows the main power or signal to pass through while unwanted noise is suppressed, improving EMI filtering and EMC performance.

Still referring to FIG. 1, the first lead frame 108 and the second lead frame 110 in the present invention functions as electrical interconnects conducting signals or power directly between the busbars 104 and the capacitors 114 mounted thereon. In addition to their electrical role, the lead frames also serve as mechanical support structures, providing a stable mounting platform for the capacitors 114 on the busbar filter 100. Furthermore, the lead frames assist in thermal management by helping to dissipate heat generated by the capacitors 114, thereby contributing to the system's stable and reliable operation. These lead frames are typically fabricated from copper, copper alloys, or nickel-plated steel, selected for their high electrical conductivity, mechanical flexibility, and long-term reliability. In the embodiment, the first lead frame 108 and the second lead frame 110 are mounted at opposite ends of the busbars 104, with their respective leads electrically connected to the left and right busbars 104.

Still referring to FIG. 1, it is important to note that in the present invention, the busbar filter 100 also incorporates over-molding components, e.g. the first over-molding part 106 and the second over-molding part 112. As the name suggests, these over-molding parts are created through an over-molding process, where a layer of material - typically plastic - is molded over another component or assembly to create a single, integrated part. This technique combines multiple materials into an unified structure. Specifically, in the preferred embodiment, the first over-molding part 106 is formed by molding a thermoplastic compound, such as thermoplastic elastomer (TPE) or thermoplastic polyurethane (TPU), around the base components (e.g., the core 102 and busbars 104). Similarly, the second over-molding part 112 is formed by injection-molding the over-molding compound around the base components, such as the second lead frame 110. In the design of busbar filter 100, the first over-molding part 106 and second over-molding part 112 serve multiple functions: they encapsulate and secure the busbars 104 and second lead frame 110, respectively; they insulate the electrical paths between the components; and they provide mechanical stability and environmental protection. Additionally, depending on product requirements, the first lead frame 108 may also be provided with a third over-molding part 109 to enhance its functionality. The following embodiment will focus on the second over-molding part 112 as an example to illustrate the application of the over-molding component within the busbar filter 100 of the present invention.

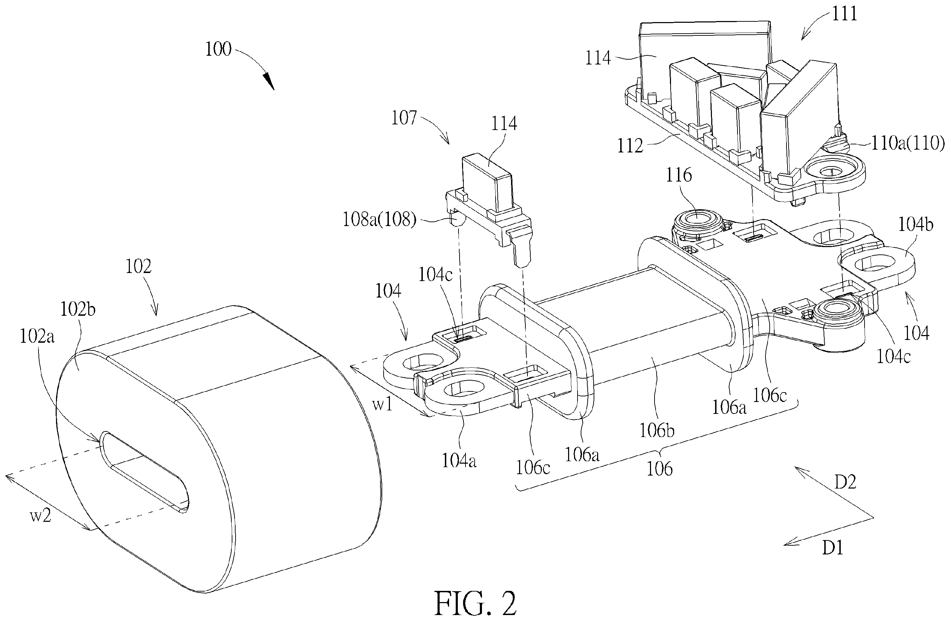

Refer now to FIG. 2, an exploded view of the busbar filter 100 is presented in accordance with a preferred embodiment of the present invention. In this embodiment, the first over-molding part 106 and the second over-molding part 112 are each molded around the busbars 104 and the second lead frame 110, respectively. The first over-molding part 106 encapsulates nearly the entire length of the busbars 104, with the exception of the portions of first end 104a and second end 104b, which are left exposed for electrical connection to the input and output of the circuit system, as well as the mounting holes 104c for securing the first and second lead frames 108, 110. The first over-molding part 106 is essentially molded around the base components of the core 102 and busbars 104, comprising specific features, such as two fixed stops 106a, a middle portion 106b positioned between the fixed stops 106a, and two outer portions 106c located on either outer side of the two fixed stops 106a. Upon assembly, the busbars 104, together with the first over-molding part 106, extend through the central through hole 102a of the core 102, with the first and second end 104a, 104b of the busbars 104, along with the two outer portions 106c of the first over-molding part 106, are positioned on opposite sides of the core 102 in a first direction D1 (i.e. the longitudinal direction of the busbars 104). The core 102 is positioned between the two fixed stops 106a of the first over-molding part 106, with the middle portion 106b filling up the through hole 102a of the core 102. A distance w1 between two outer sides of the two busbars in the second direction D2 is smaller than a hole width w2 of the through hole 102a in the core 102 in the second direction D2. The two fixed stops 106a effectively limit and secure the position of the core 102 in relation to the busbars 104. Specifically, the core 102 includes two side planes 102b defined by a normal vector in the first direction D1, and the two fixed stops 106a extends in a second direction D2 perpendicular to the first direction D1 along the two side planes 102b respectively and do not exceed a boundary of the two side planes 102b in the second direction D2.

Still referring to FIG. 2, in the preferred embodiment, the mounting holes 104c of the busbars 104 are left exposed from the two outer portions 106c of the first over-molding part 106. This ensures that the lead frames 108, 110 and busbars 104 are properly aligned within the filter assembly. The leads 108a, 110a of the first and second lead frames 108, 110 may pass through these mounting holes 104c and are soldered on the opposite side, establishing both electrical connection and mechanical stability. Furthermore, in this embodiment, the second over-molding part 112 and the outer portion 106c of the first over-molding part 106 at the second end 104b of the busbar 104 are equipped with corresponding grounding bushings 116, which are exposed from the over-molding material. The second over-molding part 112, along with the second lead frame 110 inside, is securely fixed to the first over-molding part 106 using fastening screws or bolts (not shown) that pass through the two grounding bushings 116. Additionally, for enhanced input and output filtering, at least one capacitor 114 is mounted on both the first and second lead frames 108, 110, with the over-molding compound (ex. second over-molding part 112) serves as an insulating barrier, improving isolation performance between the components. In the present invention, the capacitor 114, together with the first and second lead frames 108 and 110 and the first and second over-molding parts 109 and 112, respectively forms a first capacitor assembly 107 and a second capacitor assembly 111. These capacitor assemblies are electrically and/or structurally symmetrical, and together with the core 102 and busbar 104, form an LC-type common mode filter. In some embodiments, the filtering function can be achieved by a common mode inductor composed only of the busbars 104 and the core 102, without including the aforementioned two capacitor assemblies. The filtering requirements of the power system can be met by adjusting the size or material of the core 102.

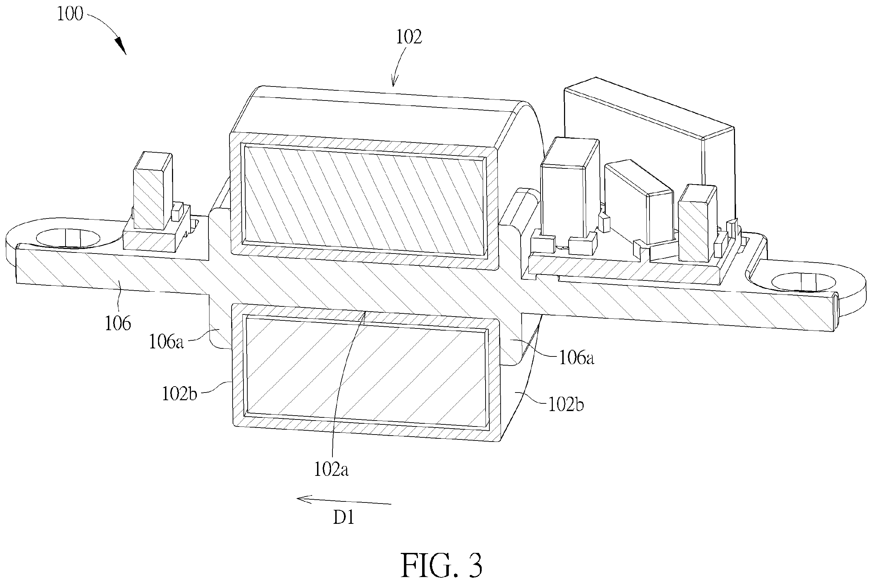

Please refer to FIG. 3, which presents a cross-sectional view of the busbar filter 100 taken along the section line A-A' in FIG. 2, in accordance with the preferred embodiment of the present invention. Preferably, the first over-molding part 106 does not cover or only partially covers the outer surface (e.g., the side planes 102b) of the core 102. Preferably, the first over-molding part 106 fills up the through hole 102a of the core 102 and covers the openings of the through hole 102a at both side planes 102b of the core 102, with the two fixed stops 106a of the first over-molding part 106 limit and secure the position of the core 102 in relation to the busbars 104.

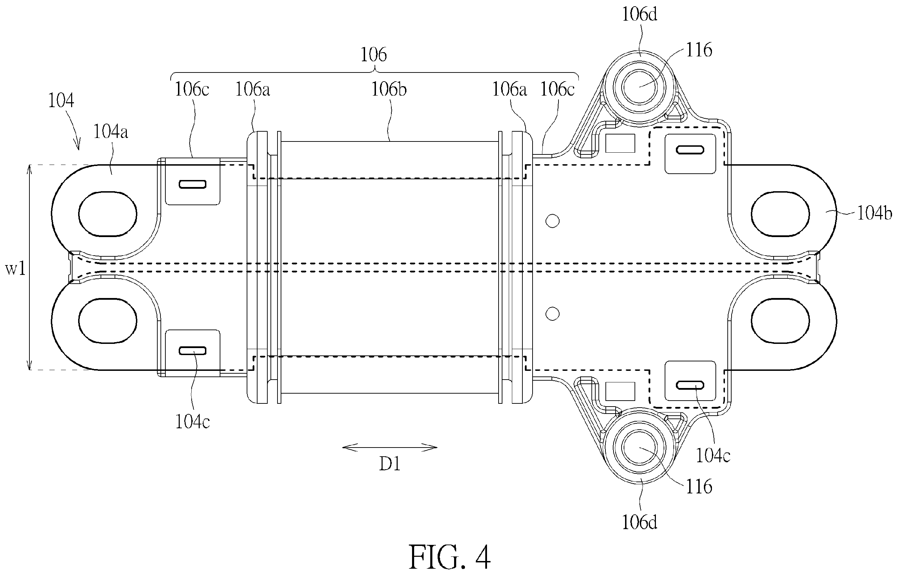

Refer now to FIG. 4, which presents a top view of the busbars 104 and the first over-molding part 106 molded thereon in accordance with the preferred embodiment of the present invention. The busbars 104 in this embodiment are formed as solid conductive strips or bars arranged in parallel and extending along the first direction D1. While only two busbars 104 are shown in the figure, it should be readily understood by those skilled in the art that the number of busbars 104 is not limited to two. In the basic design, each busbar 104 includes a first end 104a and a second end 104b, positioned opposite one another along the first direction D1, and functioning respectively as the input and output terminals for the busbar filter. Additionally, each busbar 104 is provided with two mounting holes 104c, located near the first and second end 104a and 104b, respectively. In the preferred embodiment, each mounting hole 104c on one busbar 104 corresponds to the mounting hole 104c at the same end of the other busbar 104, allowing for precise alignment and secure attachment of lead frames. Importantly, in the present invention, a first over-molding part 106 is molded around the busbars 104. As illustrated in FIG. 4, the first over-molding part 106 encapsulates nearly the entire length of the busbars 104, with the exception of the first and second ends 104a, 104b and the through hole 104c, which are intentionally left exposed to allow for electrical connection and mechanical assembly.

Still referring to FIG. 4, in the preferred embodiment, the first over-molding part 106 includes several defined structural features - two fixed stops 106a, a middle portion 106b positioned between the fixed stops 106a, and two outer portions 106c located on either outer sides of the two fixed stops 106a. As previously described with reference to FIG. 2, after assembly, the core 102 is securely positioned between the two fixed stops 106a, which serve to precisely limit and stabilize the core's position relative to the busbars 104. Additionally, in the preferred embodiment, the outer portion 106c of the first over-molding part 106 near the second end 104b is provided with two ear features 106d. These ear features 106d extend in a direction perpendicular to the first direction D1, and each is configured to house a grounding bushing 116, which is exposed from the over-molding material. These bushings are designed to receive fastening elements such as screws or bolts (not shown), enabling secure grounding and mechanical attachment.

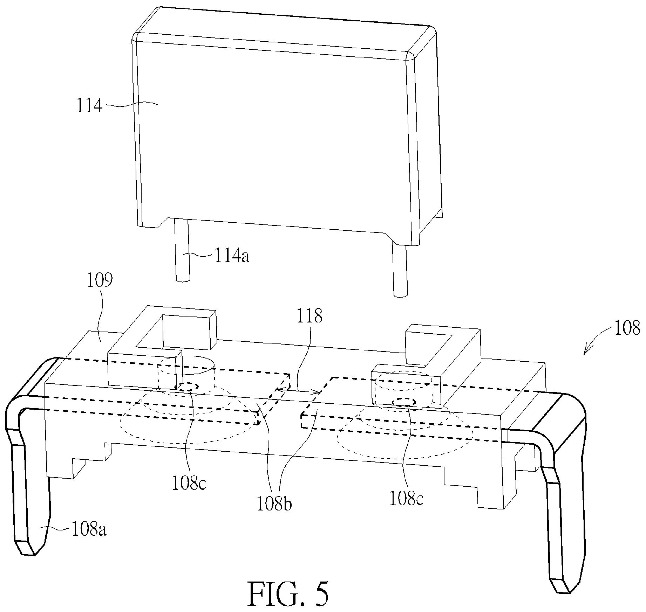

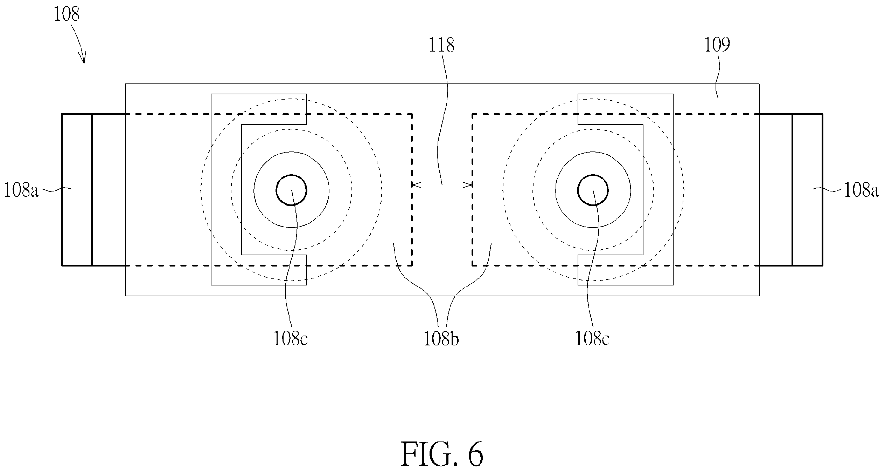

Refer now to FIG. 5 and FIG. 6 collectively, which present a perspective view and a top view of the first lead frame 108 in accordance with the preferred embodiment of the present invention. In the embodiment, the first lead frame 108 is composed of two separated conductive portions 108b, which are electrically insulated from each other. This insulation is provided by the third over-molding part 109, which encapsulates the first lead frame 108, leaving two leads 108a exposed for electrical connection to the busbars 104 through the through holes 104c (see FIG. 2). With respect to the separated conductive portions 108b, each of the separated conductive portions 108b is provided with at least one terminal portion 108c exposed from the third over-molding part 109, facilitating electrical connections to the capacitor 114. The capacitor 114 is mounted on the first lead frame 108, with its two terminals 114a electrically connected to the respective terminal portions 108c on the two separated conductive portions 108b of the first lead frame 108. The capacitor 114 in this embodiment may serve as a battery-side capacitor in the electric vehicles (EVs) power system, with the two terminals 114a of the capacitor 114 and the two terminal portions 108c of the first lead frame 108 corresponds to the two busbars 104, which, for example, are electrically connected to the HV+ and HV- input terminals of line impedance stabilization network (LISN) in a high-voltage power system based on EVs power architecture. In the embodiment, a gap 118 exists between the two separated conductive portions 108b, with the shortest distance between them. In this design, the third over-molding part 109 fills the gap 118, enhancing the isolation between the separated conductive portions 108b. This configuration helps to reduce the insulation distances, in line with safety standards, while also optimizing the overall product size. In the embodiment, a spacing of the gap between the two busbars 104, or between the separated conductive portions 108b, 108c, is within a range of 1.0 mm to 3.2 mm.

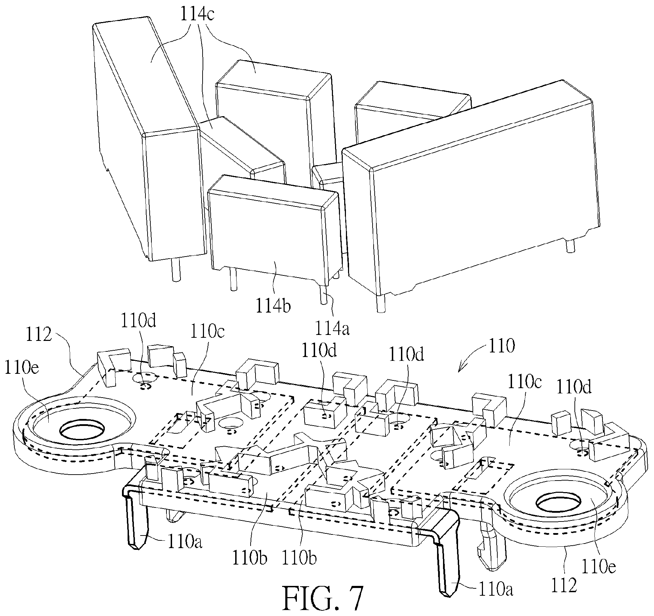

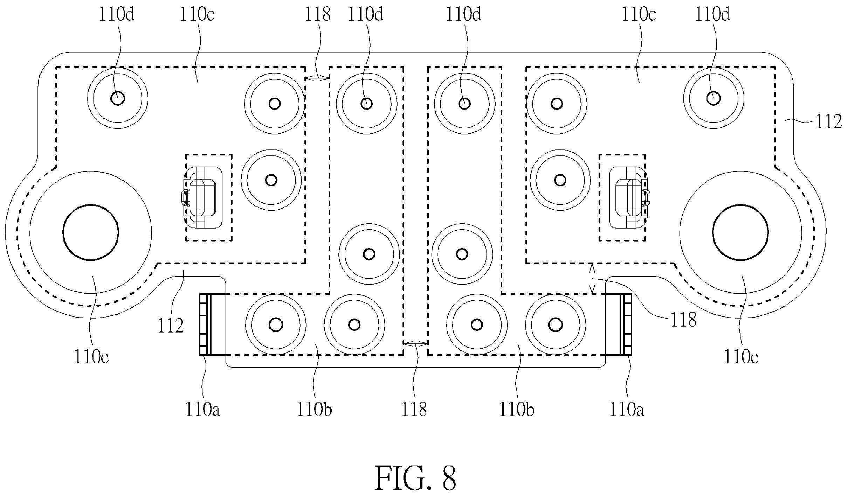

Refer now to FIG. 7 and FIG. 8 collectively, which present a perspective view and a top view of the second lead frame 110 in accordance with the preferred embodiment of the present invention. In the embodiment, similarly, the second lead frame 110 is composed of four separated conductive portions 110b and 110c, which are electrically insulated from each other. This insulation is provided by the second over-molding part 112, which encapsulates the second lead frame 110, leaving two leads 110a at the conductive portions 110b exposed for electrical connection to the busbars 104 through the through holes 104c (FIG. 2). With respect to the separated conductive portions 110b and 110c, each of the separated conductive portions 110b, 110c is provided with at least one terminal portion 110d exposed from the second over-molding part 112, facilitating electrical connections to the capacitors 114b, 114c. The capacitors 114b, 114c are mounted on the second lead frame 110, with their two terminals 114a electrically connected to the respective terminal portions 110d on the two separated conductive portions 110b, 110c of the second lead frame 110. The capacitor 114b, 114c in this embodiment may serve as an inverter-side capacitor in the electric vehicles (EVs) power system.

Unlike the conductive portions 108b of the first lead frame 108, the second lead frame 110 in the preferred embodiment includes two types of conductive portions - 110b and 110c - designed respectively for output terminal connection and grounding. As illustrated in FIG. 7 and FIG. 8, the two terminals 114a of the center capacitor 114b are connected two terminal portions 110d belonging to the two conductive portions 110b. These conductive portions 110b are further electrically connected to the two busbars 104, which, for instance, correspond to the HV+ and HV- output terminals connected to an inverter in a high-voltage power system based on EVs power architecture. On the other hand, the two terminals 114a of the side capacitor 114c are connected respectively to one terminal portions 110d of the conductive portions 110b and one terminal portions 110d of the conductive portions 110c, thereby forming a grounding path for the capacitor 114c. The conductive portion 110c of the second lead frame 110 is grounded through a designated grounding portion 110e, which, after assembly, is electrically connected to the grounding bushing 116 on the first over-molding part 106 (see FIG. 2) via fastening screws or bolts (not shown). To ensure sufficient electrical isolation, a gap 118 exists between the separated conductive portions 110b and 110c, representing the shortest insulation distance. In this design, the second over-molding part 112 fills the gap 118, effectively enhancing the isolation between the two conductive regions. This approach not only supports compliance with electrical safety standards but also contributes to the optimization of the product's overall size.

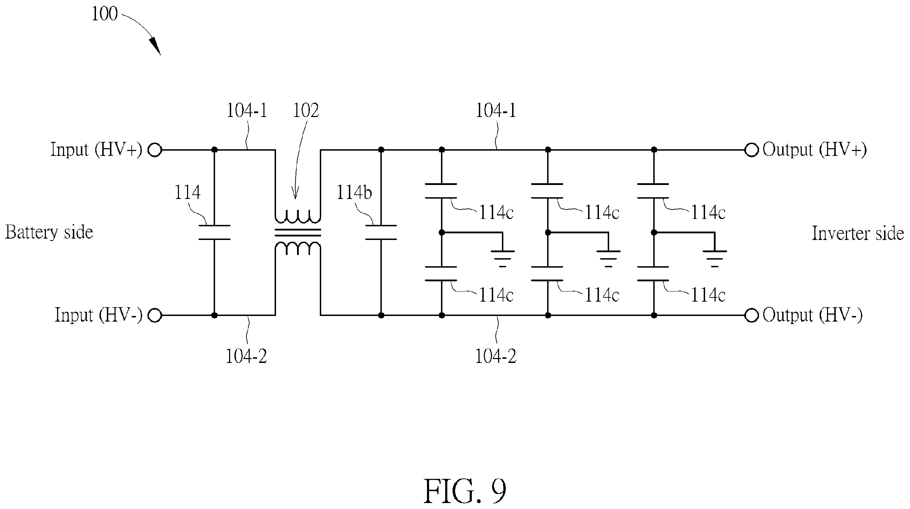

Referring now to FIG. 9, which presents a schematic diagram of the busbar filter 100 in accordance with a preferred embodiment of the present invention, this design demonstrates the application of the busbar filter 100 as an automotive filter positioned between the battery and the inverter in electric vehicles (EVs) and hybrid electric vehicles (HEVs). This critical component facilitates the transfer of high-power DC (direct current) from the battery - via the line impedance stabilization network (LISN) - to the inverter, which subsequently converts the DC power into AC (alternating current) to drive the electric motor, such as a permanent-magnet synchronous motor (PMSM). In this system, HV+ and HV- represent the high-voltage positive and negative busbars, respectively, which carry the high-power DC between the battery and the inverter. During the power conversion process, high-frequency noise and electromagnetic interference (EMI) are often generated, particularly due to switching operations in the inverter. The busbar filter 100 is strategically positioned between the HV+ and HV- lines to mitigate these high-frequency disturbances. By filtering out unwanted EMI, the busbar filter 100 ensures stable and clean power delivery, thus meeting stringent electromagnetic compatibility (EMC) requirements and safeguarding the integrity of the vehicle's overall electrical system.

As illustrated in FIG. 9, the input (HV+) and input (HV-) on the battery side are connected to the first busbar 104-1 and second busbar 104-2, respectively. A capacitor 114 (i.e., the capacitor 114 mounted on the first lead frame 108 in FIG. 5) is connected in parallel between the first busbar 104-1 and the second busbar 104-2 through the first lead frame 108. The first and second busbar 104-1 and 104-2 pass through the core 102, effectively filtering out high-frequency noise and EMI. These busbars are then further connected to the output (HV+) and output (HV-) on inverter side. On inverter side, a capacitor 114b (i.e., the center capacitor 114b mounted on the second lead frame 110 in FIG. 7) is connected in parallel between the first and second busbars 104-1 and 104-2 (via the conductive portions 110b of the second lead frame 110 in FIG. 7). Additionally, a plurality of capacitors 114c (i.e., the side capacitors 114c mounted on the second lead frame 110 in FIG. 7) are connected in parallel between the first and second busbars 104-1 and 104-2, with one terminal connected to the busbar 104-1 or 104-2 (via the conductive portion 110b in FIG. 7) and the other terminal grounded (via the conductive portion 110c in FIG. 7).

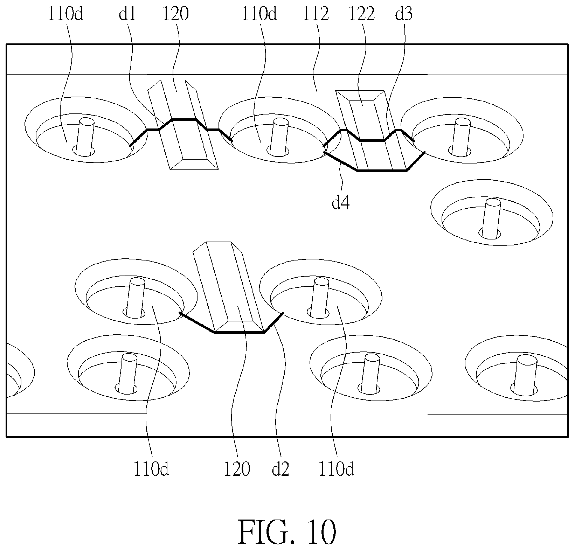

Referring to FIG. 10, which presents an enlarged view of the second over-molding part 112 in accordance with an embodiment of the present invention, this design leverages the second over-molding part to enhance the creepage distance between the terminal portions of the second lead frame. As shown in the figure, the presence of the second over-molding part 112 over the second lead frame increases the creepage distance between the two terminal portions 110d of the second lead frame that connect to a capacitor. This increase in creepage distance is a result of the inherent thickness of the over-molding material. The creepage distance is defined as the shortest distance measured along the insulating surface (e.g., the second over-molding part 112) between two adjacent conductors (e.g., the capacitor), following the actual path along a curved, bent, or straight trajectory on the insulating surface. Furthermore, in this embodiment, the second over-molding part 112 is further provided with raised features 120 and/or recessed features 122, which protrude and/or recessed from the insulating surface of the second over-molding part 112. Theses raised features 120 and recessed features 122 are designedly formed between the two terminal portions 110d of the lead frame, effectively increasing the creepage distances d1-d4. The raised features 120 and recessed features 122 ensure that the creepage distance is increased regardless of whether the current path passes directly through the raised features 120 and recessed features 122 (e.g., creepage distances d1 and d3) or bypasses them (e.g., creepage distances d2 and d4). It should be noted that the raised and recessed features referred to in the present invention are defined with respect to the reference insulating plane of the over-molding part, e.g., second over-molding part 112.

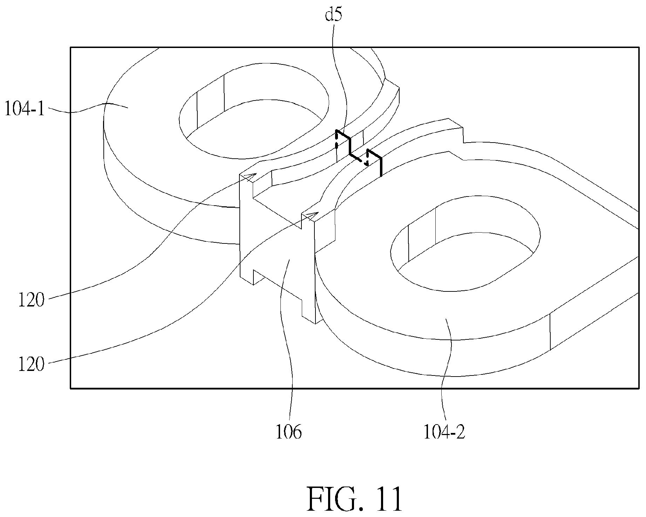

Referring to FIG. 11, which presents an enlarged view of the two busbars 104-1 and 104-2, along with the first over-molding part 106 molded onto them in accordance with an embodiment of the present invention. This design is different from the previous embodiment. In this embodiment, the raised feature 120 is formed along the insulating surface (e.g., the first over-molding part 106) between two adjacent conductors (e.g., the two busbars 104-1 and 104-2). Similar to the previous embodiment, the raised feature 120 increases the creepage distance d5 by providing a longer straight path along the uneven surface of the raised feature 120.

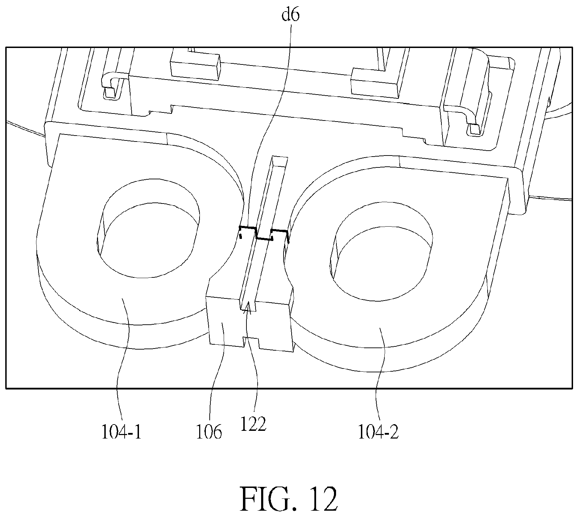

Referring to FIG. 12, which presents an enlarged view of the two busbars 104-1 and 104-2, along with the first over-molding part 106 molded onto them in accordance with an embodiment of the present invention. Similar to the previous embodiment, in this embodiment, the recessed feature 122 is formed along the insulating surface (e.g., the first over-molding part 106) between two adjacent conductors (e.g., the two busbars 104-1 and 104-2). The recessed feature 122 increases the creepage distance d6 by providing a longer straight path along the uneven surface of the recessed feature 122.

Both the aforementioned recessed feature 122 and the raised feature 120 in the present invention can be used together on the over-molding part between the conductors (e.g. the busbars and the conductive portions of the lead frame), further enhancing the isolation performance of the device. This design not only improves electrical isolation but also contributes to reducing the required safety distance and overall product size and production costs.

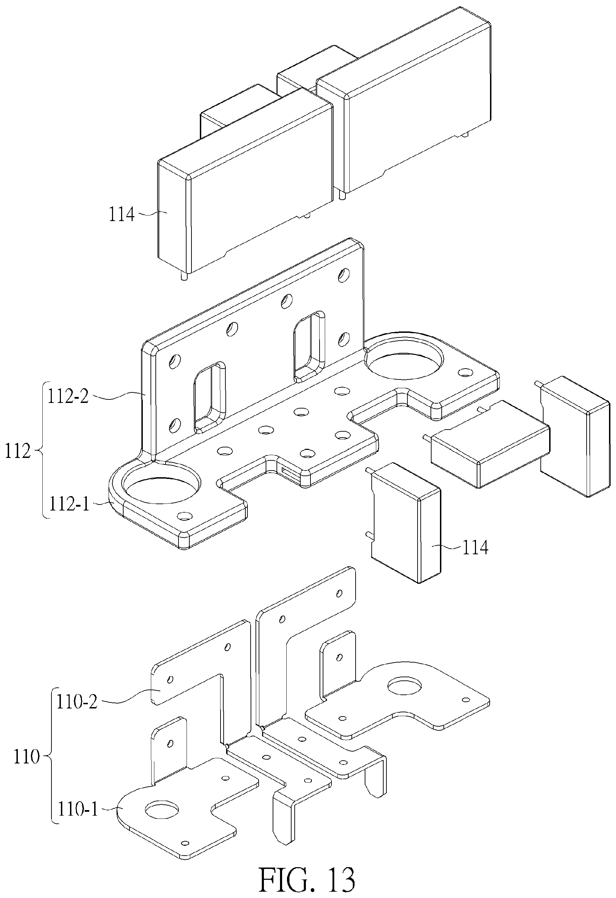

Referring to FIG. 13, which presents an exploded view of the second lead frame 110 along with the second over-molding part 112 molded onto it and the capacitor 114 mounted thereon in accordance with an alternative embodiment of the present invention. In addition to the benefits provided by the over-molding parts as described before, a key feature of the present invention is the use of a lead frame to replace traditional PCBs for electrical connection between the busbars and the capacitors. Due to the manufacturing process involved, the second lead frame 110 can be easily fabricated with a horizontal portion 110-1 and a vertical portion 110-2 by simply stamping and bending the material into the desired shape. Correspondingly, the over-molding process can effortlessly form the second over-molding part 112 along the surface of the second lead frame 110, irrespective of the mold complexity introduced by the 3D contours of the lead frame. The resulting second over-molding part 112 is also equipped with a corresponding horizontal portion 112-1 and vertical portion 112-2. This approach offers significant flexibility, enabling 3D placement of the capacitors 114, which greatly enhances space utilization and reduces production costs. In contrast, the conventional method requires the use of two separate PCBs connected by pins to form the horizontal and vertical portions, a process that is not only more complex but also significantly more expensive.

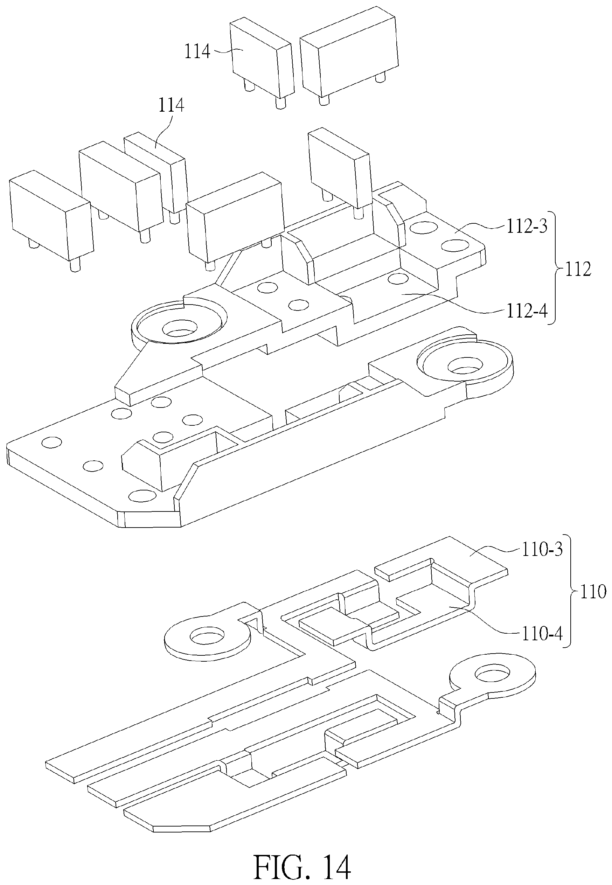

Referring to FIG. 14, which presents an exploded view of the second lead frame 110 along with the second over-molding part 112 molded onto it and the capacitor 114 mounted thereon in accordance with an alternative embodiment of the present invention. Similar to the previous embodiment, the simple manufacturing process of the second lead frame 110 allows for easy fabrication of the lead frame with two mounting surfaces, 110-3 and 110-4, at different heights by stamping and bending the material into the desired shape. Correspondingly, the over-molding process seamlessly form the second over-molding part 112 along the surface of the second lead frame 110, regardless of the mold complexity introduced by the uneven contour of the lead frame. The resulting second over-molding part 112 is also equipped with corresponding mounting surfaces 112-3 and 112-4 at different heights, wherein at least one of the capacitor 114 will be mounted on each of the mounting surfaces 112-3 and 112-4. This design offers significant flexibility, allowing capacitors 114 to be placed at varying heights, thereby greatly improving space utilization and reducing production costs. In contrast, the conventional PCB approach can only provide a single, level mounting plane, which results in inefficient use of space when capacitors of different heights need to be placed.

Another advantage of using lead frames to replace the PCB for electrical connections in busbar filter is that the lead frame's thickness is not subject to the same limitations as that of a PCB. While the thickness of copper layers in PCB is typically limited to a maximum of 6 oz, meeting critical current and temperature requirements often necessitates the use of thicker copper layers in parallel connection. In contrast, lead frame does not face this restriction, increasing the thickness of the lead frame can easily accommodate these requirements. For example, a thickness of the first lead frame and the second lead frame is greater than 0.07 mm or within a range of 0.2 mm to 4.0 mm, and preferably between 0.4 mm and 4.0 mm. This provides significant advantages in both manufacturing processes and cost efficiency.

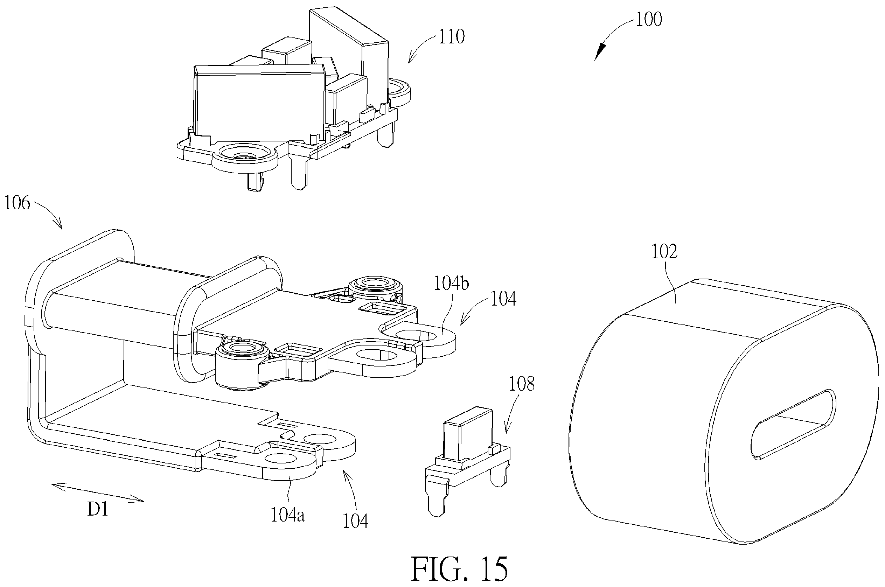

Referring to FIG. 15, which presents an exploded view of the busbar filter 100 with bent busbars 104 in accordance with an alternative embodiment of the present invention, in addition to the aforementioned adjustments in the lead frames and over-molding parts, further modifications are made to the busbar design in the present invention. Specifically, the busbar 104 is reconfigured to provide benefits in reducing the size of the busbar filter 100. As illustrated in FIG. 15, in this embodiment, the first ends 104a of the two busbars 104 are bent toward the same side of the core 102, aligning with the second ends 104b in the first direction D1. Despite this bending, the core 102 can remains positioned centrally around the busbar 104, with the bending providing sufficient space for optimal arrangement. Similarly, the first over-molding part 106 can be easily molded over the surface of the bent busbars 104, owing to its excellent conformability, regardless of the complexity introduced by the bending. This design introduces significant flexibility, allowing for a reduction in the length of the busbar filter 100 along the first direction D1. As a result, it greatly enhances space utilization and contributes to a reduction in production costs. This design also enhances inductance by increasing the overlapping area between the busbars 104 and the core 102.

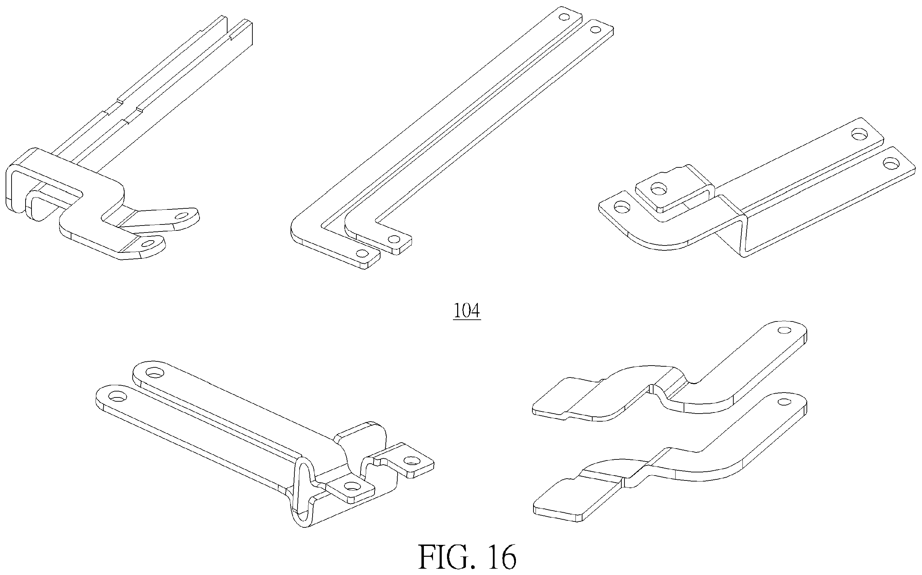

Referring to FIG. 16, which illustrates the busbars 104 in various bending configurations, the present invention allows the busbars to be bent in accordance with the design specifications, ensuring that the busbar filter meets the product requirements effectively. The bending of the busbars offers several advantages for the busbar filter design. By bending the busbars 104, it becomes possible to optimize space utilization, allowing for a more compact and efficient layout. This bending enables better flexibility in routing and placement, especially in designs with constrained space or specific form factor requirements. Additionally, bending the busbars 104 can enhance the overall inductance of the busbar filter due to an increased overlapping area between the busbars 104 and the core 102. This improves the filter's performance by effectively filtering out high-frequency noise and electromagnetic interference (EMI). Furthermore, the bending process helps to meet specific current handling and thermal dissipation needs. By adjusting the design of the bent busbars, it becomes easier to increase the surface area for heat dissipation, helping to maintain temperature control under high current conditions. This makes the design more robust, capable of handling higher power levels, and ensures that the busbar filter meets the required electromagnetic compatibility (EMC) standards. Ultimately, this approach provides a balance of improved performance, compactness, and cost-effectiveness in the busbar filter design. For a 400V model of busbar filter, compared to the traditional assembly structure, the proposed design reduces volume by 20%. For a 800V model of busbar filter, the proposed design reduces volume by 34% and cost by 7% compared to the traditional assembly structure.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A busbar filter (100), **characterized by**, comprising:
a core (102) with a through hole (102a);
two busbars (104) extending along a first direction (D1) through the through hole (102a), wherein each of the two busbars (104) comprises a first end (104a) and a second end (104b); and
a first over-molding part (106) formed on the two busbars (104) and between the two busbars (104) and the core (102), wherein the first over-molding part (106) fills up gaps (118) between the two busbars (104) and a remaining space in the through hole (102a).

2. The busbar filter (100) of claim 1, **characterized in that** further comprising a first capacitor assembly (107) or/and a second capacitor assembly (111) electrically connected to the first ends or/and the second ends of the two busbars, respectively.

3. The busbar filter (100) of claim 2, **characterized in that** the first capacitor assembly (107) and the second capacitor assembly (111) are electrically and/or structurally symmetrical.

4. The busbar filter (100) of claim 2, **characterized in that** the first capacitor assembly (107) and the second capacitor (111) assembly further comprising:
a first lead frame (108) mounted on the first ends (104a) of the two busbars (104), and at least one first capacitor (114) mounted on the first lead frame (108);
a second lead frame (110) mounted on the second ends (104b) of the two busbars (104), and at least one second capacitor (114) mounted on the second lead frame (110); and
a second over-molding part (112) molded on the second lead frame (110), wherein the second over-molding part (112) fills up gaps (118) in the second lead frame (110).

5. The busbar filter (100) of claim 4, **characterized in that** each of the two busbars (104) comprises a first mounting hole (104c) at the first end (104a) and exposed from the first over-molding part (106), and the first lead frame (108) comprises two leads (108a), and the two leads (108a) of the first lead frame (108) are mounted respectively in the first mounting holes (104c) of the two busbars (104).

6. The busbar filter (100) of claim 4, **characterized in that** each of the two busbars (104) comprises a second mounting hole (104c) at the second end (104b) and exposed from the first over-molding part (106), and the second lead frame (112) comprises two leads (110a), and the two leads (110a) of the second lead frame (110) are mounted respectively in the second mounting holes (104c) of the two busbars (104).

7. The busbar filter (100) of claim 4, **characterized in that** the second lead frame (110) comprises a horizontal portion (110-1) and a vertical portion (110-2) vertically connected to the horizontal portion (110-1), and at least one of the second capacitors (114) is mounted on the horizontal portion (110-1) and at least one of the second capacitors (114) is mounted on the vertical portion (110-2).

8. The busbar filter (100) of claim 4, **characterized in that** the second lead frame (110) comprises a plurality of mounting surfaces (110-3, 110-4) at varying heights, and at least one of the second capacitor (114) is mounted on each of the mounting surfaces (110-3, 110-4).

9. The busbar filter (100) of claim 4, **characterized in that** the second lead frame (110) further comprises two grounding portions (110e) exposed from the second over-molding part (112), and two grounding bushings (116) are provided in the first over-molding part (106) at the second ends (104b) of the two busbars (104), and the second lead frame (110) are fixed on the two busbars (104) by fastening screws or bolts through the two grounding portions (110e) and the corresponding grounding bushings (116).

10. The busbar filter (100) of claim 4, **characterized in that** the second lead frame (110) comprises a plurality of separated conductive portions (110b, 110c), wherein the gaps (118) in the second lead frame (110) are between the separated conductive portions (110b, 110c).

11. The busbar filter (100) of claim 10, **characterized in that** two terminals (114a) of the second capacitor (114) are connected with two of the separated conductive portions (110b, 110c) respectively.

12. The busbar filter (100) of claim 10, **characterized in that** each of the separated conductive portions (110b, 110c) of the second lead frame (110) comprises at least one terminal portion (110d) exposed from the second over-molding part (112) for electrically connecting the second capacitor (114), and the second over-molding part (112) further comprises a raised feature (120) between two of the adjacent terminal portions (110d) of the different separated conductive portions (110b, 110c) that connecting two terminals (114a) of the second capacitor (114).

13. The busbar filter (100) of claim 10, **characterized in that** each of the separated conductive portions (110b, 110c) of the second lead frame (110) comprises at least one terminal portion (110b, 110c) exposed from the second over-molding part (112) for electrically connecting the second capacitor (114), and the second over-molding part (112) further comprises a recessed feature (122) between two of the adjacent terminal portions (110d) of the different separated conductive portions (110b, 110c) that connecting two terminals (114a) of the second capacitor (114).

14. The busbar filter (100) of claim 10, **characterized in that** a spacing between the two busbars (104) or between the separated conductive portions (110b, 110c) is within a range of 1.0 mm to 3.2 mm.

15. The busbar filter (100) of claim 4, **characterized in that** a thickness of the first lead frame (108) and the second lead frame (110) is greater than 0.07 mm or within a range of 0.2 mm to 4.0 mm, and preferably between 0.4 mm and 4.0 mm.

16. The busbar filter (100) of claim 1, **characterized in that** each of the two busbars (104) comprises an input terminal (104a) and an output terminal (104b) exposed from the first over-molding part (106).

17. The busbar filter (100) of claim 1, **characterized in that** the first over-molding part (106) further comprises two fixed stops (106a) respectively at two sides of the core (102) in the first direction (D1), and the two fixed stops (106a) fixed a position of the core (102) with respect to the two busbars (104).

18. The busbar filter (100) of claim 17, **characterized in that** the core comprises two side planes (102b) defined by a normal vector in the first direction (D1), and the two fixed stops (106a) extends in a second direction (D2) perpendicular to the first direction (D1) along the two side planes (102b) respectively and do not exceed a boundary of the two side planes (102b) in the second direction (D2).

19. The busbar filter (100) of claim 18, **characterized in that** the first over-molding part (106) does not cover or only partially covers an outer surface of the core (102), and the first over-molding part (106) covers an opening of the through hole (102a) at both of the side planes (102b) of the core (102).

20. The busbar filter (100) of claim 1, **characterized in that** the first ends (104a) of the two busbars (104) are bent toward the same side of the core (102) as the second ends (104b) in the first direction (D1).

21. The busbar filter (100) of claim 1, **characterized in that** the first over-molding part (106) further comprises a raised feature (120) or a recessed feature (122) between the two busbars (104-1, 104-2).

22. The busbar filter (100) of claim 1, **characterized in that** the first over-molding part (106) fixed the two busbars (104) and the core (102) and electrically insulates the two busbars (104) and the core (102).

23. The busbar filter (100) of claim 1, **characterized in that** a distance (w1) between two outer sides of the two busbars (104) is smaller than a hole width (w2) of the through hole (102a) in the core (102).
